# EUROPEAN PATENT SPECIFICATION

(11) **EP 1 693 898 B1**
(45) Date of publication and mention of the grant of the patent: **16.04.2008**
(21) Application number: 05447039.8
(22) Date of filing: 21.02.2005
(51) Int. Cl.: H01L 29/786, H01L 27/12, H01L 21/336, H01L 27/108, H01L 29/78

(54) **Floating-body-cell memory device and a method for the manufacturing thereof**
Halbleiterspeicherbauelement mit schwebendem Körper und Herstellungsverfahren desselben
Dispositif semi-conducteur de mémoire à corps flottant et son procédé de fabrication

(43) Date of publication of application: 23.08.2006
(73) Proprietor: INTERUNIVERSITAIR MICROELEKTRONICA CENTRUM ( IMEC), 3001 Leuven (BE)
(72) Inventor: Haspeslagh, Luc, 3210 Lubbeek-Linden (BE); Rosmeulen, Maarten, 3000 Leuven (BE)
(74) Representative: Van Malderen, Joëlle

(56) References cited:
- WO-A-20/04038770
- DE-A1- 10 204 871
- US-A1- 2005 017 240
- RANICA R ET AL: "A one transistor cell on bulk substrate (1T-bulk) for low-cost and high density eDRAM" VLSI TECHNOLOGY, 2004. DIGEST OF TECHNICAL PAPERS. 2004 SYMPOSIUM ON HONOLULU, HI, USA JUNE 15-17, 2004, PISCATAWAY, NJ, USA,IEEE, 15 June 2004 (2004-06-15), pages 128-129, XP010732820 ISBN: 0-7803-8289-7

## Description

### Field of the invention

The present invention relates generally to semiconductor devices, in particular to FinFET CMOS memory devices and to methods for manufacturing such devices.

### State of the art

When processing electronic data this data needs to be stored in memory cells. These memory cells can either be integrated as a stand-alone memory in a dedicated memory chip or can be embedded on the logic chip containing the data processing circuitry. Embedded memory cells offer the advantage of providing a fast data access for such logic circuitry, but because these embedded memory cells are placed on the same semiconductor substrate as the logic circuitry, stringent conditions are imposed on the power and the area consumed by the embedded memory cells. Preferably the embedded memory cells are formed by the same semiconductor technology manufacturing sequence as used to form the logic cells or, at least, with a minimum number of additional process steps. Typically RAM (random access memory) memory cells are used as embedded memory as this memory concept offers that fastest data access to individual bits. RAM memory cells are often labelled as being volatile, because the data contained in such RAM memory cell is lost when the power of the chip is switched off.

The urge for continuous improvement regarding overall manufacturing cost and circuit performance leads to a scaling down of the semiconductor technology and to the design of ever more complex data processing circuitry requiring larger amounts of memory, resulting in an ever-increasing footprint of the memory blocks for a given chip area. For years the classic six transistor SRAM (static RAM) cells have been used to embed RAM memory cells in logic circuitry. As such SRAM cell is made up of 6 transistors, it is quite area consuming, typically 150 F², with F being the minimal feature size for a given semiconductor process technology generation, e.g. 65nm or 45nm. Hence if the memory blocks are to take up a major part of the silicon estate, SRAM cells will constitute an area-expensive alternative for embedded memory. On the other hand, DRAM (dynamic RAM) memory cells have as main advantage their small cell size. A DRAM cell typically is made up of 1 transistor and 1 capacitor, which fit in an area of 8 F². However, DRAM technology is very complex. It is therefore affordable to use it to make stand-alone memory chips. However when embedding DRAM memory cells into a chip containing logic circuitry, an cost increase of 25% to 30% renders the making of embedded DRAM again a very process-expensive solution. There is clearly a need for an embedded RAM technology, which requires less chip area than the SRAM approach and which can be manufactured in a semiconductor technology, less complex than the DRAM approach. Different alternatives for such embedded RAM technology have been proposed.

In US patent application US-6744676 a 1T-SRAM concept is introduced storing the data on the capacitor associated with a transistor. Although this alternative does offer an area reduction with substantially increasing process complexity to the process, the gain in area depends on the technology generation in which the embedded memory cell is manufactured. For older technologies, so-called large technology nodes e.g. having a minimal feature size F above 0.13 µm, the reduction in area consumption compared to the SRAM approach is considerable. As the capacitor area doesn't scale with technology this area reduction becomes negligible when going to smaller technologies nodes.

M. Tack et al. propose in 'The multistable charge-controlled memory effect in SoI MOS transistors at Low Temperatures' (IEEE Transactions on Electron Devices, vol.37, No.5, May 1990, pp.1373-1382*)* to employ the multistable charge-controlled memory effect in Silicon-on-Insulator (SoI) MOS transistors as the basic mechanism for building RAM memory cells. By injection of charge, either by tunnelling or by impact ionisation, into the body of an SoI transistor the threshold voltage of this transistor changes as function of the amount of injected charge. This memory effect is also exploited in United States patent US-6621725 and European patent EP1355361. Although the technologies disclosed require the use of SoI-wafer as starting substrate, Ranica et al in 'A one transistor cell on bulk substrate (1T-bulk) for low-cost and high-density eDRAM' (2004 Symposium on VLSI Technology, pp.128-129*)* disclose this multistable charge-controlled memory effect to be obtainable on a bulk wafer whereby, instead of an oxide, a buried implant is used to isolate the body of the transistor from the bulk of the wafer. Although the latter approach allows for an embedded RAM technology, requiring less chip area than the SRAM approach and manufacturable in a semiconductor technology, less complex than the DRAM approach, it doesn't allow a good control over the amount of charge stored and the preservation thereof. Hence there is a need for an embedded RAM memory device, which offers a better control over the storage and preservation of charge in the body of a transistor. Preferably this embedded memory device requires less chip area. Preferably this embedded memory device can be a manufactured in a semiconductor manufacturing process sequence for logic devices without increasing process complexity.

Patent application DE10204871-A1 discloses a capacitorless one-transistor DRAM cell. The channel region and the source-drain regions are arranged vertically at a sidewall of a dielectric trench filling. On the opposite side, the semiconductor material is bounded by the gate dielectric and the gate electrode, which is arranged in a cutout of the semiconductor material. A memory cell array comprises a multiplicity of vertically oriented strip-type semiconductor regions in which source-drain regions are implanted at the top and bottom and a channel region embedded in insulating material on all sides is present in between as a floating body. WO 2004/038770 discloses a FinFET-based DRAM device.

### Aims of the invention

The present relates to an embedded memory device capable of storing charge in the semiconductor body of the device while keeping better control over the storage and preservation of charge. It further relates to a method for manufacturing such devices.

### Summary of the invention

The invention relates to a device for storing charge as defined in claim 1 and to a manufacturing method thereof as defined in claim 13. Particular embodiments are defined in the dependent claims.

### Short description of the drawings

Fig. 1 represents a cross-section along the fin of a prior art SoI memory device in the body of which charge can be stored.

Fig. 2 represents a top view of a charge storing device according to the invention comprising two narrower outer sections and one wider inner section sandwiched in-between.

Fig. 3 schematically represents a cross-section AA of the device of Fig. 2.

Fig. 4 represents the electrical equivalent scheme of the device shown in Fig. 2.

Fig. 5 represents a charge storing device with only one connecting region.

Figs. 6a and 6b represent alternative embodiments of the charge storing device.

Fig. 7 represents the definition of cross-sectional area.

Fig. 8 represents a top view of a twin-gate device according to an embodiment comprising two gates.

Fig. 9 represents the electrical equivalent scheme of device shown in Fig. 8.

Fig. 10 represents a top view of a charge storing device comprising two narrower outer sections and one wider inner section sandwiched in-between, each section having its own gate.

Fig. 11 represents a cross-section AA of the device shown in Fig.10.

Fig. 12 represents a top view of a device according to an embodiment of the invention comprising an asymmetric position of the body (12).

Fig. 13 represents a top view of a device according to an embodiment of the invention comprising multiple outer sections (13) and multiple bodies (12).

Fig. 14 represents the use of a device in maskless lithography according to an embodiment of the invention.

### Detailed description of the invention

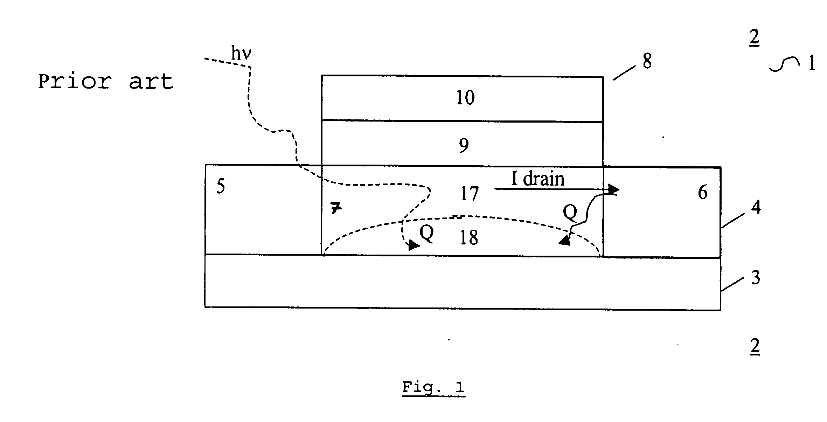

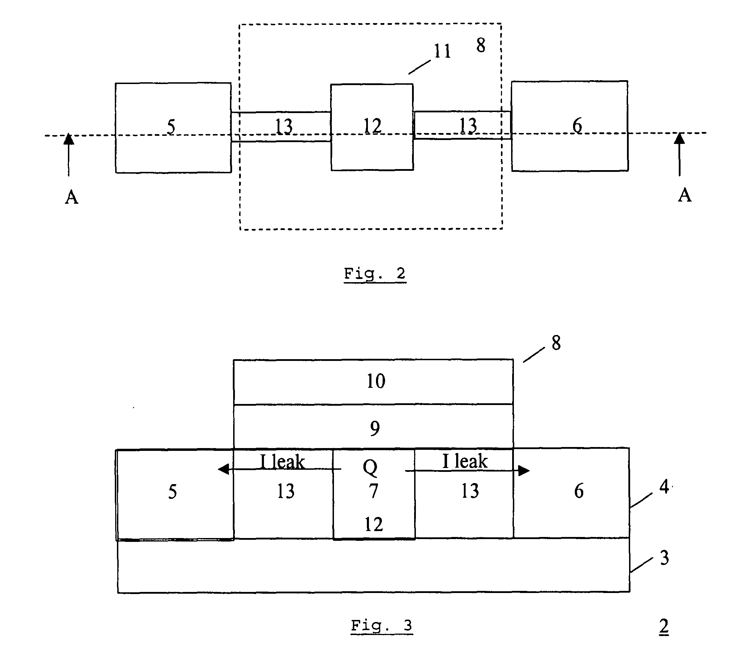

Figure 1 schematically shows a state-of-the-art SoI FinFET device that can be used as embedded memory device. In a semiconductor layer 4 a semiconductor core 7 is provided between a source region 5 and a drain region 6. Semiconductor core 7 is covered with a gate 8. The gate is composed of a gate dielectric stack 9 comprising at least one dielectric, e.g. oxide, and a gate electrode 10 like e.g. polycrystalline silicon, germanium or metal. The physical characteristics of source 5 and drain 6 are obtained by providing a specific doping profile therein. Injection of carriers into the semiconductor core 7 of the transistor modulates the threshold voltage of the transistor. This charge will leak way Iₗₑₐₖ via the junctions between the core having one dopant type (e.g. p-type dopant) and the source 5/drain 6 having another dopant type (e.g. n-type dopant).
Charge can be introduced into the semiconductor core of the device in various ways, e.g. by impact ionisation, tunnelling or radiation. These mechanisms are well described in the literature. EP 1355361 and EP 1405314 describe the creation of mobile charge in the body due to impact ionisation of a drain current I_{drain} (for example Fig. 1a and 1b of EP 1355361 and corresponding paragraphs in the description), due a tunnelling current (for example Gate-induced-drain-leakage according to EP 1355361, illustrated by Fig. 2) or by electromagnetic radiation hv impinging on the semiconductor device (for example Fig. 18 of EP 1405314 and corresponding paragraph in the description). The semiconductor core (7) comprises a depleted part (17) of the body and a neutral part (18) for storing the mobile charge therein.

Figs. 2 and 3 show a preferred embodiment of a device for storing charge according to the invention. It is represented as a FinFET device, comprising between a source region (5) and a drain region (6) a gate (8) provided with a fin (11). The gate overlies the fin at three sides : the top surface and the two sides. When applying a voltage between the source and the drain region the charge carriers in the channel are driven by the electrical field between source and drain. The channel comprises an inner section (body 12) for storing charge therein and two connecting regions (13) connected to the body. Through connecting regions (13) charge is supplied to and from the body (12). As shown in Fig.2 the connecting regions (13) have a cross-sectional area smaller than the cross-section of the charge storing body (12). As the middle part of the channel is made wider than the outer parts, the channel region gets divided in three parts.

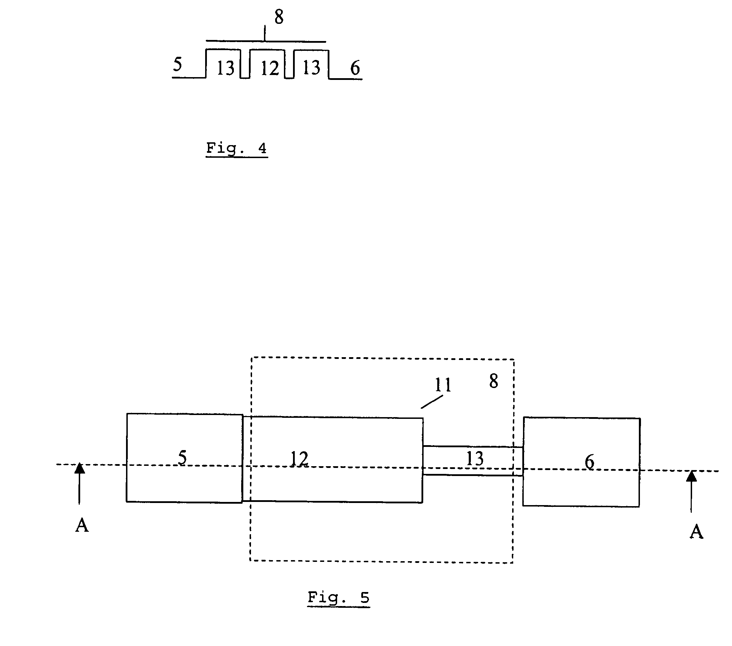

The outer parts of the channel can be considered as transistors having a thin fin and can operate therefore as fully depleted SoI transistors. This means that no mobile charge can be stored in these regions. Small width allows full control over charge within the fin and hence full depletion can be obtained. The middle part is made large in such a way that a partially depleted device is created, leaving room for a neutral part of the body (12) to accumulate free charge. Fig.4 represents the electrical equivalent scheme of the device shown in Fig. 2.

Using this structure, the charge collected in the body of the transistor is confined to the central part of the device, away from the junctions. The leakage current of the junction, which is governed by trap-assisted band-to-band tunnelling, no longer determines the leakage of the charge. The gate, independently from the junction potential, controls the depletion region separating the stored charge and the source/drain junctions. This means that the electric field near the source-drain junctions is also reduced, without the need for complicated junction engineering to obtain low leakage junctions.

In a device for storing charge according to the invention it suffices to have at least one connecting region with a cross-sectional area smaller than the cross-section of the body (12), as for example in Fig.5. The narrower channel part (13) creates a physical barrier for the leakage current between the charge storing body and drain region (6). In this case other measures need to be taken (e.g. applying a suitable dopant profile) in order to deal with the leakage current between body (12) and the source (5).

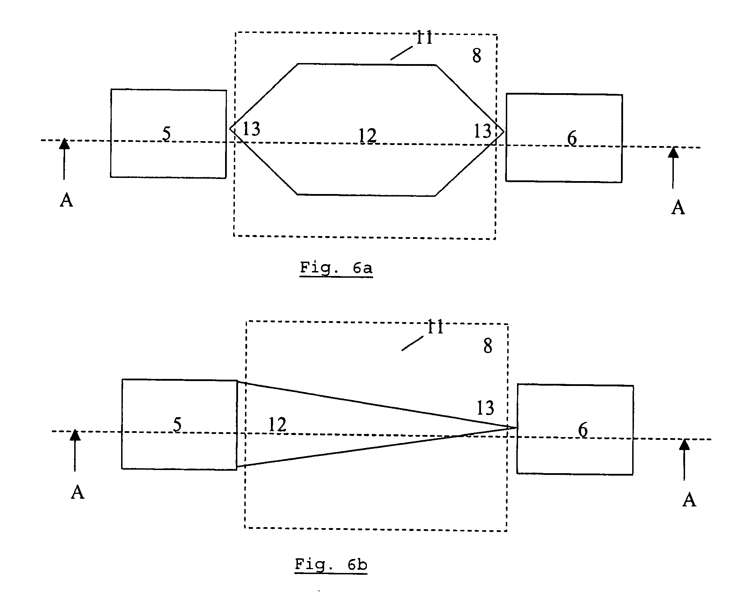

Figs. 6a and 6b show alternative embodiments of the charge storing device. These figures merely aim to emphasise that any shape is possible for fin (11), as long as a narrowing is provided at at least one side of the charge storing device with geometrical means, such that charge is prevented from leaking away from the body at that at least one side.

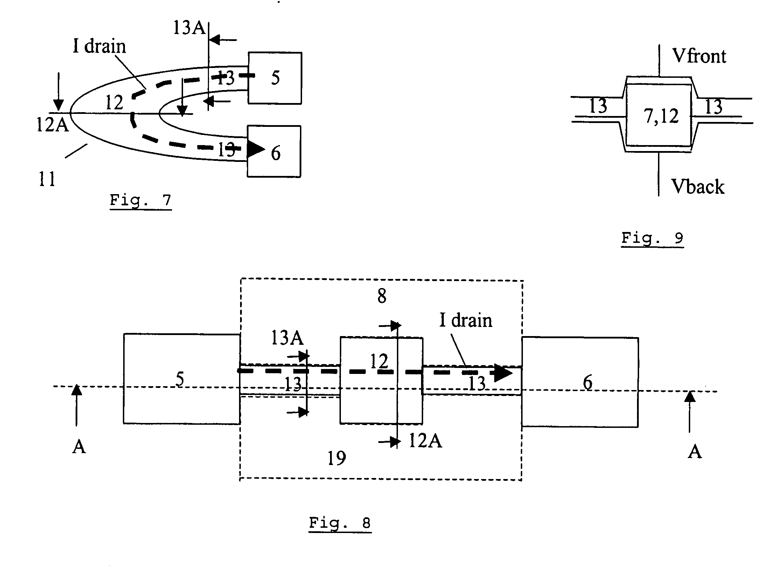

Fig.7 explains that the cross-sectional area of a connecting region or a charge storing body is to be taken in a direction perpendicular to the charge supplying direction. The charge supplying direction is indicated with a dashed line. Even with the unusual shape of the channel in Fig.7 the cross-sectional area is not everywhere the same between source and drain region (see cross-section at position 12A vs.13A).

In a preferred embodiment the device comprises at least one gate electrode dielectrically coupled to the body. The presence of two gates can be used on the one hand to modulate the potential of the body ('backbias') and on the other hand to independently control the on/off state of the device ('frontbias') (see Figs. 8 and 9). Such a twin gate is advantageous if a fully depleted device is used. Fig. 8 also indicates with a dashed line the charge supplying direction, which defines the cross-sectional areas to be considered : they are perpendicular to the charge supplying direction.

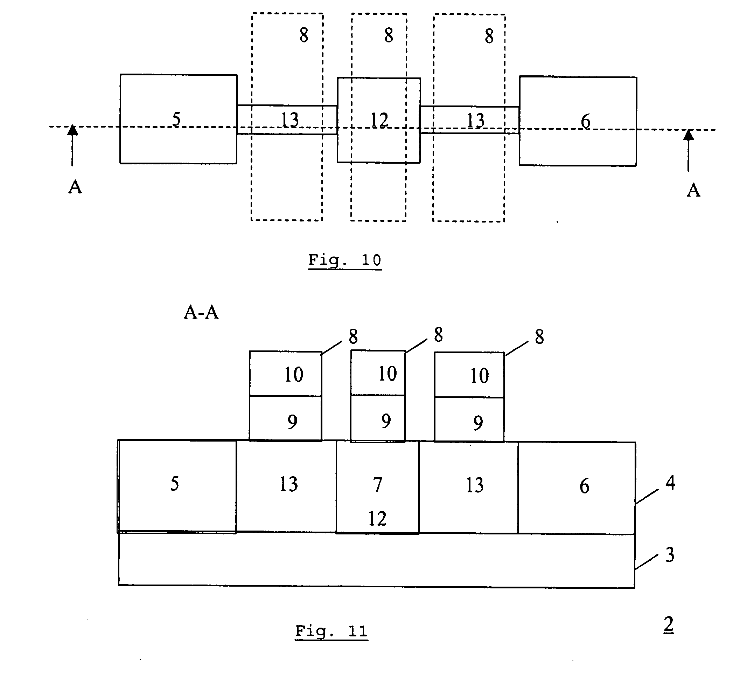

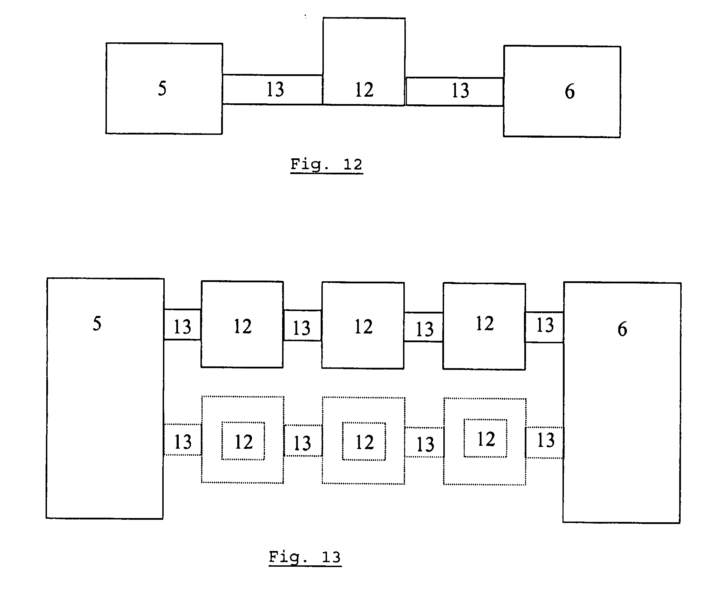

As shown in Fig.10 (and cross-sectional view in Fig.11) at least one gate electrode may further be provided for each connecting region. The gate electrode(s) are dielectrically coupled to the connecting region. At least two of the electrodes can be electrically coupled. In a further embodiment the formation of different 'front' gates is considered: i.e. one gate overlapping the inner portion and two other gates, each overlapping an outer portion. The inner gate and the two outer gate operate independently, i.e. they can be biased to different voltages on different moments in time, while preferably the two outer gates should be connected to ensure an identical biasing of the two outer gates. Fig.12 on the other hand shows a top view of a device according to an embodiment of the invention comprising an asymmetric position of the body (12) .

One can also consider using multiple sets of sections (12)/(13) in series. In a specific embodiment the charge storing device comprises more than one body (12). Fig.13 gives such an example, wherein both possibilities are combined: two parallel sets of bodies/outer sections in series are provided between source 5 and drain 6.

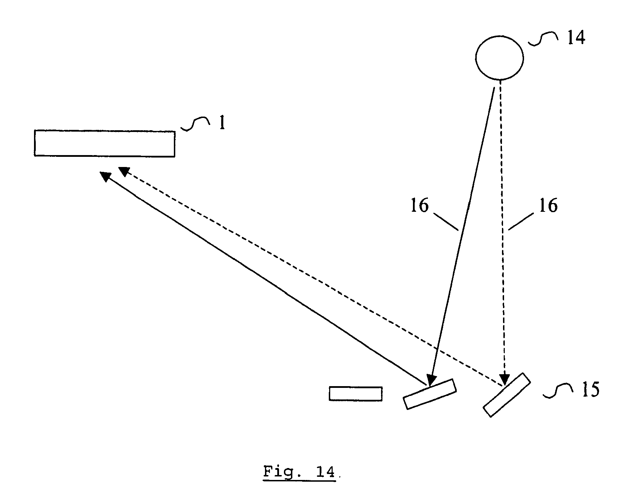

Other uses of the device should be discussed, e.g. as sensor or detector. Charge stored in the body of the device can also originate from electromagnetic radiation. In this case the device can be used in maskless lithography to calibrate the operation of the illumination mechanism. Fig.14 illustrates the projection of light (16) from a light source (14), reflected by the mirrors (15) towards an array (1) of memory devices according to the invention. The distribution of the charge over the array (1) is indicative of the light pattern applied.

The present invention also relates to a method for fabricating a charge storing device and an embedded memory device as previously described. Methods for manufacturing FinFET devices are known in the art, for example from patent applications EP1498958A2 and EP1503424A2. To the person skilled in the art deposition techniques are thus known to form a layer enveloping the body of the charge storing device. To create a fin with varying width only one litho step is to be performed : when lithographically defining the fin 11 the desired layout of the fin, i.e. having a non-constant cross-section along its longitudinal direction, is printed. This sequence is fully compatible with a known process form manufacturing FinFETS as in its basic forms it only requires the local modification of the fin for the memory devices, while for the logic devices the width of the fin remains constant.

## Claims

1. Device for storing charge comprising an electrically floating body (12) for storing charge therein, and at least one connecting region (13) connected to said body and arranged for supplying charge to and from said body, said body and said at least one connecting region being made of a semiconductor material and being located between the source and the drain of a field effect transistor (FET), said body (12) being dielectrically coupled with a gate electrode of said FET, **characterised in that** at least one of said at least one connecting region has a cross-sectional area smaller than the cross-section of said charge storing body, said cross-sectional area being perpendicular to the charge supplying direction.

2. Device for storing charge as in claim 1, comprising two connecting regions.

3. Device for storing charge as in claim 2, wherein one connecting region is further connected to said source and one connecting region is connected to said drain.

4. Device for storing charge as in claim 1, 2 or 3, comprising more than one body.

5. Device for storing charge as in claim 1, further comprising for each connecting region at least one gate electrode dielectrically coupled to said connecting region.

6. Device for storing charge as in claim 5, wherein at least two of said gate electrodes are electrically connected.

7. Device for storing charge as in any of the previous claims, wherein said charge storing device is a FinFET device.

8. Device for storing charge as in any of the previous claims, wherein said device is formed on a substrate, said substrate being dielectrically insulated from said device.

9. Device for storing charge as in claim 8, wherein said substrate is a semiconductor-on-insulator structure.

10. Device for storing charge as in claim 9, wherein said semiconductor-on-insulator structure is a silicon-on-insulator or a germanium-on-insulator structure.

11. Device for storing charge as in claim 8, wherein said substrate is a bulk semiconductor substrate.

12. Memory device comprising a device for storing charge as in any of the claims 1 to 11.

13. Method for fabricating a charge storing device as in any of the previous claims, comprising the steps of
- providing a substrate with a semiconductor layer,
- patterning said semiconductor layer to form a source, a drain and a fin therein, said fin comprising an electrically floating body for storing charge therein, and at least one connecting region and
- forming a gate over said fin,
**characterised in that** said patterning step comprises the step of forming said body and said at least one connecting region between said source and said drain, said at least one connecting region having a cross-sectional area smaller than the cross-section of said charge storing body, said cross-sectional area being perpendicular to the charge supplying direction.

## Patentansprüche

1. Vorrichtung für die Ladungsspeicherung, umfassend einen elektrisch potenzialfreien Körper (12), um darin Ladung zu speichern, und mindestens einen Verbindungsbereich (13), der an den Körper angeschlossen und dafür eingerichtet ist, dem Körper Ladung zuzuführen und von ihm abzuführen, wobei der Körper und der mindestens eine Verbindungsbereich aus einem Halbleitermaterial bestehen und zwischen der Source und dem Drain eines Feldeffekttransistors (FET) angeordnet sind, wobei der Körper (12) dielektrisch an eine Gate-Elektrode des FET gekoppelt ist, **dadurch gekennzeichnet, dass** mindestens einer von dem mindestens einen Verbindungsbereich eine Querschnittsfläche aufweist, die kleiner ist als der Querschnitt des ladungsspeichernden Körpers, wobei die Querschnittsfläche senkrecht zur Ladungszuführungsrichtung ist.

2. Vorrichtung für die Ladungsspeicherung nach Anspruch 1, die zwei Verbindungsbereiche umfasst.

3. Vorrichtung für die Ladungsspeicherung nach Anspruch 2, wobei ein Verbindungsbereich ferner mit der Source und ein Verbindungsbereich mit dem Drain verbunden sind.

4. Vorrichtung für die Ladungsspeicherung nach Anspruch 1, 2 oder 3, die mehr als einen Körper umfasst.

5. Vorrichtung für die Ladungsspeicherung nach Anspruch 1, ferner für jeden Verbindungsbereich mindestens eine Gate-Elektrode umfassend, die dielektrisch an den Verbindungsbereich gekoppelt ist.

6. Vorrichtung für die Ladungsspeicherung nach Anspruch 5, wobei mindestens zwei der Gate-Elektroden elektrisch verbunden sind.

7. Vorrichtung für die Ladungsspeicherung nach einem der vorhergehenden Ansprüche, wobei die Ladungsspeicherungsvorrichtung eine FinFET-Vorrichtung ist.

8. Vorrichtung für die Ladungsspeicherung nach einem der vorhergehenden Ansprüche, wobei die Vorrichtung auf einem Substrat ausgebildet ist, wobei das Substrat dielektrisch von der Vorrichtung isoliert ist.

9. Vorrichtung für die Ladungsspeicherung nach Anspruch 8, wobei das Substrat eine Halbleiter-auf-Isolator-Struktur ist.

10. Vorrichtung für die Ladungsspeicherung nach Anspruch 9, wobei die Struktur Halbleiter-auf-Isolator eine Struktur Silizium-auf-Isolator oder Germanium-auf-Isolator ist.

11. Vorrichtung für die Ladungsspeicherung nach Anspruch 8, wobei das Substrat ein kompaktes Halbleitersubstrat ist.

12. Speichervorrichtung, die eine Vorrichtung für die Ladungsspeicherung nach einem der Ansprüche 1 bis 11 umfasst.

13. Verfahren zur Herstellung einer Ladungsspeicherungsvorrichtung nach einem der vorhergehenden Ansprüche, das die Schritte umfasst:
- Bereitstellen eines Substrats mit einer Halbleiterschicht
- Formung der Halbleiterschicht zum Ausbilden einer Source, eines Drain und einer Lamelle darin, wobei die Lamelle einen elektrisch potenzialfreien Körper, um darin Ladung zu speichern, und mindestens einen Verbindungsbereich umfasst, und
- Ausbilden eines Gate über der Lamelle,
**dadurch gekennzeichnet, dass** der Formungsschrittsschritt den Schritt zum Ausbilden des Körpers und des mindestens einen Verbindungsbereichs zwischen der Source und dem Drain umfasst, wobei der mindestens eine Verbindungsbereich eine Querschnittsfläche aufweist, die kleiner ist als der Querschnitt des ladungsspeichernden Körpers, wobei die Querschnittsfläche senkrecht zur Ladungszuführungsrichtung ist.

## Revendications

1. Dispositif de stockage de charge comprenant un corps (12) flottant électriquement pour y stocker une charge, et au moins une région de connexion (13) connectée audit corps et arrangée pour distribuer une charge audit corps et depuis ledit corps, ledit corps et ladite au moins une région de connexion étant constitués d'un matériau semi-conducteux et étant situés entre la source et le drain d'un transistor à effet de champ (FET), ledit corps (12) étant diélectriquement couplé à une électrode de grille dudit FET, **caractérisé en ce qu'**au moins une de ladite au moins une région de connexion a une section en coupe transversale plus petite que la section transversale dudit corps de stockage de charge, ladite section en coupe transversale étant perpendiculaire à la direction de distribution de la charge.

2. Dispositif de stockage de charge selon la revendication 1, comprenant deux régions de connexion.

3. Dispositif de stockage de charge selon la revendication 2, dans lequel une région de connexion est en outre connectée à ladite source et une région de connexion est connectée audit drain.

4. Dispositif de stockage de charge selon les revendications 1, 2 ou 3, comprenant plus d'un corps.

5. Dispositif de stockage de charge selon la revendication 1, comprenant en outre pour chaque région de connexion au moins une électrode de grille couplée diélectriquement à ladite région de connexion.

6. Dispositif de stockage de charge selon la revendication 5, dans lequel au moins deux desdites électrodes de grille sont électriquement connectées.

7. Dispositif de stockage de charge selon l'une quelconque des revendications précédentes, dans lequel ledit dispositif de stockage de charge est un dispositif FinFET.

8. Dispositif de stockage de charge selon l'une quelconque des revendications précédentes, dans lequel ledit dispositif est formé sur un substrat, ledit substrat étant isolé diélectriquement dudit dispositif.

9. Dispositif de stockage de charge selon la revendication 8, dans lequel ledit substrat est une structure semi-conducteur sur isolant.

10. Dispositif de stockage de charge selon la revendication 9, dans lequel ladite structure semi-conducteur sur isolant est une structure silicium sur isolant ou germanium sur isolant.

11. Dispositif de stockage de charge selon la revendication 8, dans lequel ledit substrat est un substrat semi-conducteur massif.

12. Dispositif de mémoire comprenant un dispositif de stockage de charge selon l'une quelconque des revendications 1 à 11.

13. Procédé pour fabriquer un dispositif de stockage de charge selon l'une quelconque des revendications précédentes, comprenant les étapes consistant à :
- disposer une couche de semz-conducteur sur un substrat,
- configurer ladite couche de semi-conducteur pour y former une source, un drain et une ailette, ladite ailette comprenant un corps flottant électriquement pour y stocker une charge, et au moins une région de connexion, et
- former une grille sur ladite ailette,
**caractérisé en ce que** ladite étape de configuration comprend l'étape consistant à former ledit corps et ladite au moins une région de connexion entre ladite source et ledit drain, ladite au moins une région de connexion ayant une section en coupe transversale plus petite que la section transversale dudit corps de stockage de charge, ladite section en coupe transversale étant perpendiculaire à la direction de distribution de charge.
